# EUROPEAN PATENT SPECIFICATION

(11) **EP 3 432 428 B1**
(45) Date of publication and mention of the grant of the patent: **20.10.2021**
(21) Application number: 16894493.2
(22) Date of filing: 02.09.2016
(51) Int. Cl.: H01S 5/042, H01S 5/10, H01S 5/18, H01S 5/34, H01S 5/11, H01S 5/20, H01S 5/22, H01S 5/14

(54) **SEMICONDUCTOR LASER DEVICE**
HALBLEITERLASERVORRICHTUNG
DISPOSITIF LASER À SEMI-CONDUCTEUR

(30) Priority: 15.03.2016 JP 2016051671
(43) Date of publication of application: 23.01.2019
(73) Proprietor: Kabushiki Kaisha Toshiba, Minato-ku Tokyo 105-8001 (JP)
(72) Inventor: YAMANE, Osamu, Tokyo 105-8001 (JP); SAITO, Shinji, Tokyo 105-8001 (JP); KAKUNO, Tsutomu, Tokyo 105-8001 (JP); KANEKO, Kei, Tokyo 105-8001 (JP); HASHIMOTO, Rei, Tokyo 105-8001 (JP)
(74) Representative: Hoffmann Eitle
(86) International application number: PCT/JP2016/075859
(87) International publication number: WO 2017/158876

(56) References cited:
- EP-A1- 2 966 737
- EP-A1- 3 220 495
- WO-A1-2017/158871
- JP-A- 2008 218 975
- JP-A- 2013 211 542
- US-A1- 2013 343 415
- US-A1- 2016 020 581
- Y. CHASSAGNEUX ET AL: "Electrically pumped photonic-crystal terahertz lasers controlled by boundary conditions", NATURE, vol. 457, no. 7226, 8 January 2009 (2009-01-08), pages 174-178, XP055537532, London ISSN: 0028-0836, DOI: 10.1038/nature07636
- XU et al.: "Surface-emitting quantum cascade lasers with metallic photonic-crystal resonators", Applied Physics Letters, vol. 94, no. 22 1 June 2009 (2009-06-01), page 221101, XP012121449, Retrieved from the Internet: URL:https://doi.org/10.1063/1.3143652
- CHASSAGNEUX et al.: "Electrically pumped photonic-crystal terahertz lasers controlled by boundary conditions", nature, vol. 457, no. 7226 8 January 2009 (2009-01-08), pages 174-178, XP055537532, Retrieved from the Internet: URL:DOI: 10.1038/nature07636
- LIANG YONG ET AL: "Mode stability in photonic-crystal surface-emitting lasers with large", APPLIED PHYSICS LETTERS, A I P PUBLISHING LLC, US, vol. 104, no. 2, 13 January 2014 (2014-01-13), XP012180464, ISSN: 0003-6951, DOI: 10.1063/1.4861708 [retrieved on 1901-01-01]

## Description

### [Technical Field]

This invention relates to a semiconductor laser device.

### [Background Art]

When using a quantum cascade laser as a light source of a terahertz wave, a laser oscillation of 30 GHz to 30 THz is possible due to an intersubband transition of electrons.

In the case where an edge emitting quantum cascade laser is used as the light source, a collimator lens is necessary to cause the spreading laser light emitted from the end surface to be parallel light; and the exterior form of the laser device becomes large.

### [Prior Art Document]

### [Patent Document]

[Patent Document 1] JP 2009-231773 (Kokai)
Y. Chassagneux et al: "Electrically pumped photonic-crystal Terahertz lasers controlled by boundary conditions", Nature, vol. 457, no. 7226, 1 January 2009, p. 174-178, XP055537532, discloses a semiconductor laser with an active layer emitting THz laser light. A contact layer is formed on the active layer and has a plurality of pits forming a two-dimensional lattice. A metal electrode has a corresponding plurality of openings.

### [Summary of Invention]

### [Problem to be Solved by the Invention]

A semiconductor laser device is provided that is capable of emitting a terahertz wave of a plane wave with high efficiency.

### [Means for Solving the Problem]

A semiconductor laser device of an embodiment includes an active layer, a first layer, and a surface metal film. Multiple quantum well layers are stacked in the active layer; and the active layer is configured to emit laser light of a terahertz wave by an intersubband transition. The first layer is provided on the active layer and has a first surface in which multiple pits are provided to form a two-dimensional lattice. The surface metal film is provided on the first layer and has multiple openings. Each of the pits is asymmetric with respect to a line parallel to a side of the lattice. The laser light passes through the multiple openings and is emitted in a direction substantially perpendicular to the active layer.

### [Brief Description of Drawings]

[FIG. 1]

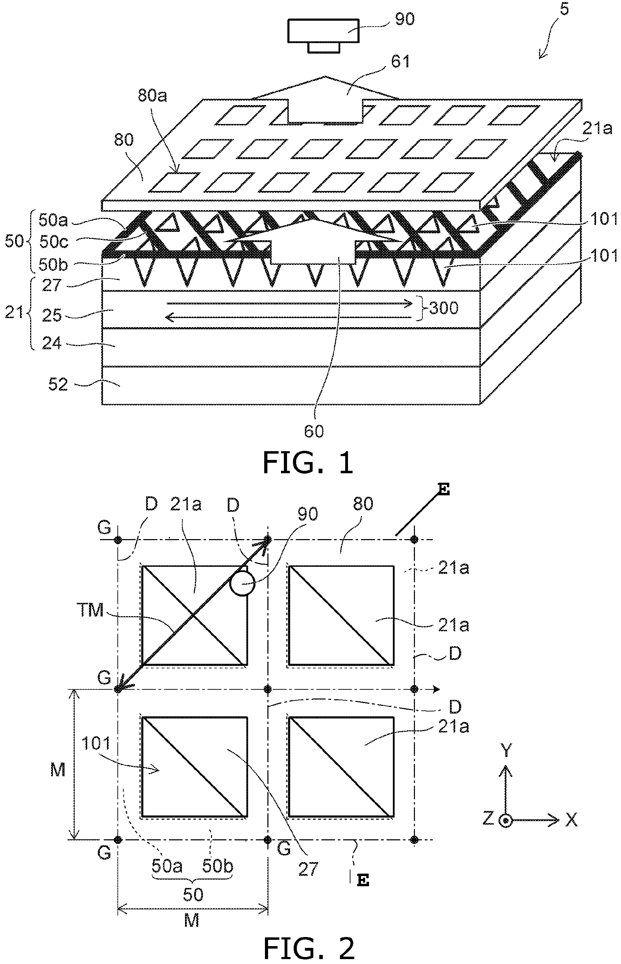

   FIG. 1 is a schematic perspective view of a semiconductor laser device according to a first embodiment of the invention.
[FIG. 2]
   FIG. 2 is a schematic plan view of the surface metal film of the semiconductor laser device according to the first embodiment.
[FIG. 3]

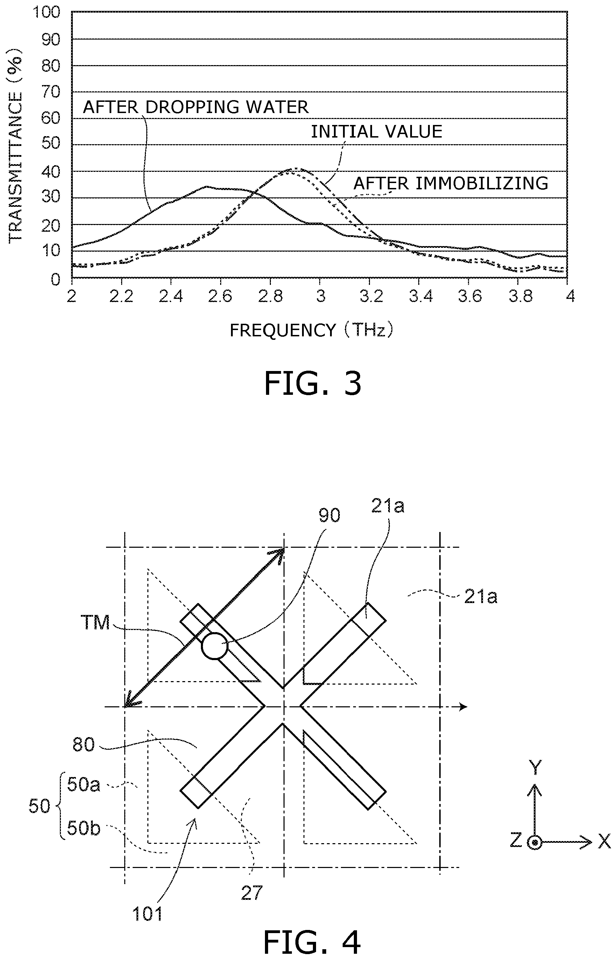

   FIG. 3 is a graph illustrating the transmittance for the frequency of the terahertz wave of the surface metal film of the semiconductor laser device according to the first embodiment.
[FIG. 4]
   FIG. 4 is a schematic plan view illustrating a modification of the surface metal film.
[FIG. 5]

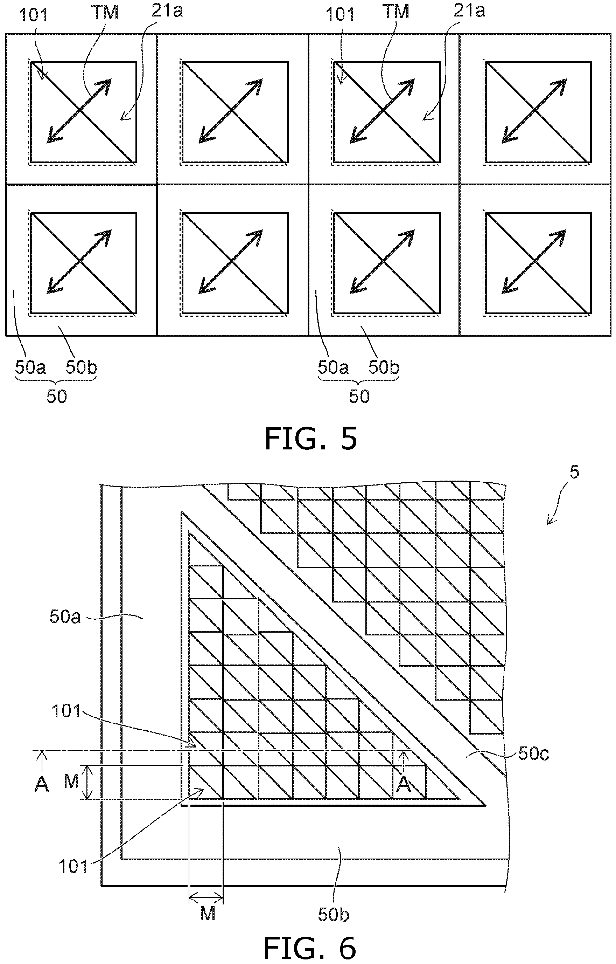

   FIG. 5 is a schematic plan view illustrating another example of the arrangement of the openings of the surface metal film.
[FIG. 6]
   FIG. 6 is a schematic plan view of the surface emitting portion of the semiconductor laser device of the first embodiment.
[FIG. 7]

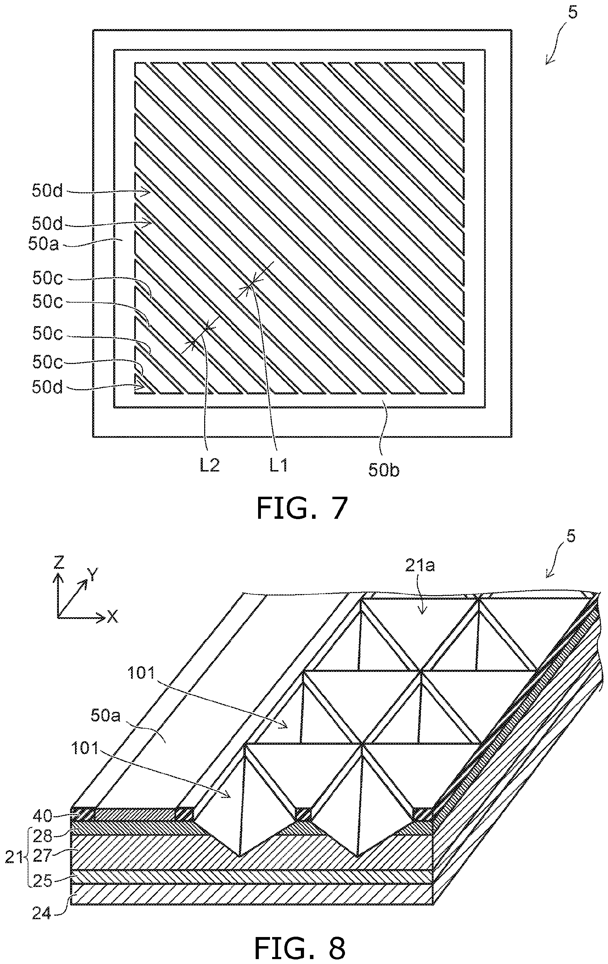

   FIG. 7 is a schematic plan view of the first electrode of the surface emitting portion.
[FIG. 8]
   FIG. 8 is a partial schematic perspective view of the pit portion.
[FIG. 9]

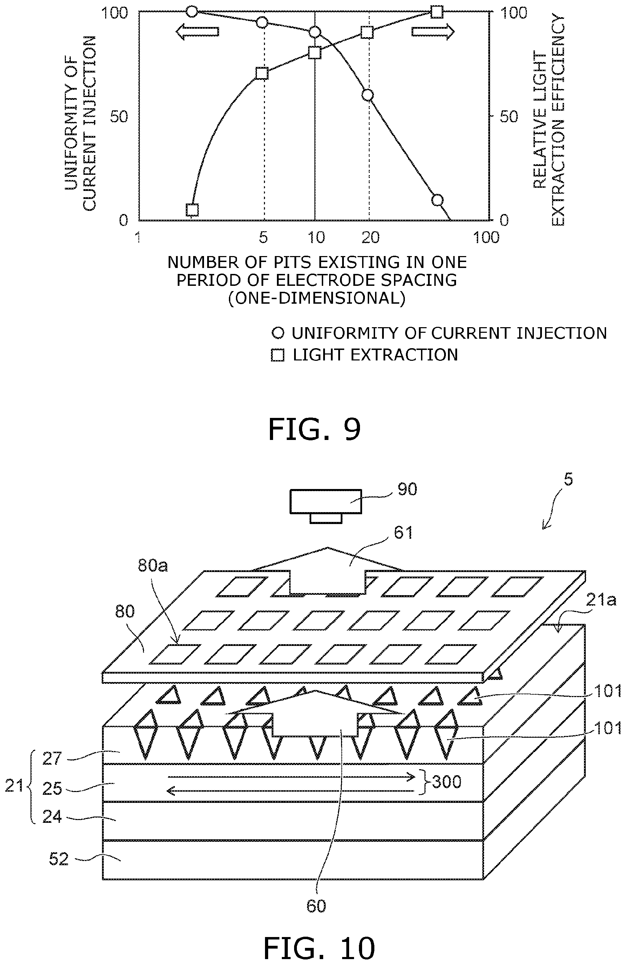

   FIG. 9 is a graph illustrating the current injection uniformity dependence and the relative light extraction efficiency dependence with respect to the number of pits.
[FIG. 10]
   FIG. 10 is a schematic perspective view of a semiconductor laser device according to a second embodiment.
[FIG. 11]

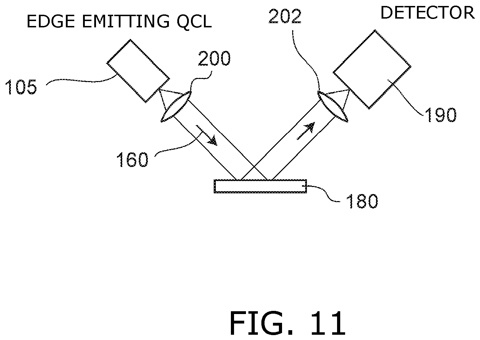

   FIG. 11 is a configuration diagram of a laser device according to a comparative example.

### [Embodiment of Invention]

Embodiments of the invention will now be described with reference to the drawings.

FIG. 1 is a schematic perspective view of a semiconductor laser device according to a first embodiment.

The semiconductor laser device 5 includes an active layer 25, a first layer 27, and a surface metal film 80. Multiple quantum well layers are stacked in the active layer 25; and the active layer 25 is configured to emit laser light of a terahertz wave by an intersubband transition. In the specification, the terahertz wave is taken to be not less than 30 GHz and not more than 30 THz.

The first layer 27 is provided on the active layer 25 and has a first surface 21a in which multiple pits 101 are provided to form a two-dimensional lattice. The surface metal film 80 is provided on the first layer 27; and multiple openings 80a are provided in the surface metal film 80. The openings 80a can be, for example, the gaps of a metal mesh, etc.

The planar configuration of each of the pits 101 is asymmetric with respect to a line parallel to a side of the lattice. Also, laser light 60 passes through the multiple openings 80a and is emitted in a direction substantially perpendicular to the front surface of the active layer 25. The light intensity of laser light 61 emitted by passing through the openings 80a of the surface metal film 80 is measured by a detector 90 such as a bolometer, etc. In the specification, the substantially perpendicular direction is not less than 81 degrees and not more than 99 degrees with respect to the front surface of the active layer 25.

In the embodiment, the semiconductor laser device 5 further includes a first electrode 50 provided between the first layer 27 and the surface metal film 80, electrically connected to the surface of the first layer 27, but insulated from the surface metal film 80. Although the surface metal film 80 is illustrated as being separated from the surfaces of the first layer 27 and the first electrode 50 in FIG. 1, actually, the surface metal film 80 is stacked with an insulating body or the like interposed.

A stacked body 21 includes the first layer 27, the active layer 25, and a second layer. The multiple pits 101 that have opening ends at the first surface 21a of the stacked body 21 are provided in a two-dimensional lattice configuration and act as a periodic-structure PC (photonic crystal). For example, the pits 101 have configurations in which triangular pyramid regions are cut out from the first surface 21a of the stacked body 21 toward the depth direction.

The laser light 60 can have optical resonance along a QCL optical resonance direction 300 inside the active layer 25; and the mode is selected by the periodic-structure PC and further emitted from the first surface 21a along an optical axis substantially perpendicular to the first surface 21a due to a diffraction effect. In other words, the region lower than the first electrode 50 functions as a surface emitting portion. A voltage is supplied above and below the stacked body 21.

FIG. 2 is a schematic plan view of the surface metal film of the semiconductor laser device according to the first embodiment.

In the drawing, one opening 80a of the surface metal film 80 is provided for four pits 101. The laser light 60 is emitted from the surface emitting portion in an upward direction substantially perpendicular to the front surface of the active layer 25, passes through the openings 80a, and is emitted to the outside. The laser light 60 is a TM (Transverse Magnetic) wave polarized in the direction of the arrow.

For the square lattice that forms the periodic-structure PC, the crossing point of two orthogonal sides D and E in the XY plane is taken as a lattice point G; and the lattice spacing of the square lattice is taken as *M*. For example, the lattice point G can be considered to be the centroid of the planar configuration of the pit 101, etc. Each of the pits 101 has non-line symmetry with respect to one side of the two sides D or E of the square lattice. The lattice may not be a square lattice and may be a lattice in which two sides are orthogonal.

A portion of the terahertz wave can pass through the opening 80a. For example, by changing the configuration and/or the size of the opening 80a, the transmittance of a terahertz wave of a wavelength of the width of the opening 80a or more can be set to 50% or more. Also, the surface metal film 80 in which the openings 80a are provided acts as an external (LC) resonator for the terahertz wave. In the case where a fine particle 90 including a dielectric adheres at the opening 80a vicinity of the surface metal film 80, the resonant frequency of the external resonator changes. Therefore, the peak frequency of the transmission spectrum shifts. In other words, the first embodiment can emit a plane wave terahertz wave with high efficiency by using a metamaterial as the surface metal film 80.

Also, in the semiconductor laser device 5 of the first embodiment, the transmission peak frequency can be shifted because the surface metal film 80 is used as an external resonator. The detection of fine particles, etc., can be performed by detecting the shift of the transmission peak frequency. For example, it is taken that the fine particle 90 including a microbe, bacteria such as coliform bacteria, or the like is adhered at the opening 80a vicinity of the surface metal film 80 of the opening 80a.

In the case where the wavelength of the laser light is near visible light, the change of the transmittance due to the fine particles 90 is reduced by the amount of a region corresponding to the cross-sectional area of the fine particles 90 and is therefore small. Conversely, in the case where the wavelength of the laser light is near a terahertz wave, the shift amount of the resonant frequency is large even if the amount of the fine particles 90 is low; therefore, the change of the transmittance is in a wide frequency range. Therefore, the existence or absence of the fine particles 90 can be detected with high accuracy. The fine particles 90 include PM 2.5, etc.

FIG. 3 is a graph illustrating the transmittance for the frequency of the terahertz wave of the surface metal film of the semiconductor laser device according to the first embodiment.

The vertical axis is the transmittance (%); and the horizontal axis is the frequency (THz) of the terahertz wave. After immobilizing coliform bacteria, water was dropped; and the transmission spectrum was measured. The initial state is illustrated by the broken line; the state after the coliform bacteria immobilization is illustrated by the dotted line; and the state after the dropping of the water is illustrated by the solid line. The transmission spectrum intensity is measurable using a spectrometer, etc.

By immobilizing the coliform bacteria, the peak frequency decreased about 25 GHz with respect to the initial state. By dropping the water, the peak frequency decreased about 300 GHz (the transmittance was about 33%). The absorption coefficient of water for the terahertz wave is high and is about 10⁶ times the absorption coefficient for visible light or the like. Therefore, the shift amount of the resonant frequency after dropping the water onto the immobilized fine particle 90 becomes large; and the detection accuracy of the fine particle 90 increases.

In the case of only water not including the fine particle 90, the shift amount of the resonant frequency is larger than the shift amount when the fine particle 90 exists. For example, a single wavelength of the laser light 60 can be set within a range including the peak vicinity of the initial spectrum and the peak vicinity of the fine particle spectrum after dropping the water.

FIG. 4 is a schematic plan view illustrating a modification of the surface metal film according to another embodiment of the invention.

In the modification of FIG. 4, the planar configuration of the opening 80a is a cross shape. In the case where the fine particle 90 is placed directly on the surface metal film 80, the chip of the semiconductor laser device 5 should be replaced after the measurement. If the fine particle 90 is placed on a plate that is transparent to the terahertz wave, it is unnecessary to replace the chip.

FIG. 5 is a schematic plan view illustrating another example of the arrangement of the openings of the surface metal film.

The pitch of the openings may be equal to the pitch M of the two-dimensional diffraction grating. Or, it is unnecessary for the pitch of the openings to be an integer multiple of the pitch M of the two-dimensional diffraction grating. In other words, it is sufficient for the openings 80a to be arranged so that the resonant frequency is shifted.

FIG. 6 is a schematic plan view of the surface emitting portion of the semiconductor laser device of the first embodiment.

The pit 101 has a configuration in which a triangular pyramid, a truncated triangular pyramid, or the like is cut out downward from the first surface 21a of the stacked body 21. The configuration of the pit 101 is not limited thereto. In the drawing, the opening end of the pit 101 is illustrated by a right triangle. The two sides that sandwich the right angle are parallel respectively to the two sides of frame portions 50a and 50b; and the oblique side is parallel to a stripe portion 50c of the first electrode 50.

The active layer 25 has a configuration in which a relaxation region is stacked alternately with an intersubband transition light emitting region made of a quantum well layer including a well layer and a barrier layer. The quantum well includes, for example, a well layer made of In_{0.669}Ga_{0.331}As doped with Si, and a barrier layer made of In_{0.362}Al_{0.638}As doped with Si. It is more favorable for the quantum well layer to have a multi-quantum well (MQW: Multi-Quantum Well) structure in which at least two well layers and multiple barrier layers are further stacked alternately. Also, the relaxation region also can include a quantum well layer.

A QCL has TM (Transverse Magnetic) polarized light of which the polarization direction is parallel to the front surface of the active layer 25; and for resonator mirrors sandwiching the active layer from the front surface and the back surface as in a p-n junction surface emitting laser, stimulated emission does not occur because the propagation directions of the light and the polarized light are aligned. In other words, it was impossible to realize a VCSEL Vertical Cavity Surface Emitting Laser: surface emitting laser).

Conversely, in the QCL according to the first embodiment, it is possible to resonate and amplify the stimulated emission light because the propagation direction of the stimulated emission light is a direction parallel to the front surface of the active layer 25. Further, in the case of a structure that is periodic and has anisotropy in the periodic structure, it is possible to extract the stimulated emission light in a direction substantially perpendicular to the front surface of the active layer 25. That is, a surface emitting laser is realizable in which the wavelength region is longer than the mid-infrared region which was previously realizable only by a QCL.

In the surface emitting laser, it is unnecessary to form a resonator by cleaving as in an edge emitting laser; and the decrease of the yield due to the cleaving can be prevented. Further, in an edge emitting laser, the resonator is first formed by the cleaving; therefore, it is necessary to perform inspections after cleaving; and the cost of inspection is high compared to an LED or the like for which the inspections can be performed using an auto-prober or the like for the wafer as-is.

Conversely, the QCL according to the first embodiment can be evaluated by an auto-prober in the wafer state; a large effect of reducing the inspection cost and/or the cost from the perspective of yield can be expected; and mass production and price reduction are easy for QCLs which had previously been expensive.

FIG. 7 is a schematic plan view of the first electrode of the surface emitting portion.

For the stripe portion 50c, the width is taken as L1; and the pitch in a direction orthogonal to the stripe portion 50c is taken as *L2.* The multiple pits 101 are disposed in the region sandwiched between the stripe portions 50c.

FIG. 8 is a partial schematic perspective view of the pit portion.

The stacked body 21 can further include a contact layer 28 on the first layer 27. Also, an insulator layer 40 of SiO₂, etc., can be provided on the first surface 21a. The surface metal film 80 can be planarized by further providing an insulator layer of SiO₂, etc., inside the pits.

FIG. 9 is a graph illustrating the current injection uniformity dependence and the relative light extraction efficiency dependence with respect to the number of pits.

The horizontal axis is the number of pits inside one period of the stripe portion 50c of the electrode; and the vertical axis is the uniformity of the current injection and the relative light extraction efficiency. In the case where the stripe portion 50c of the first electrode 50 has a one-dimensional periodic structure, the uniformity of the current injection is normalized to be 100 in the case where two pits are included inside one period along a direction orthogonal to the stripe portion 50c.

Also, in the case where the stripe portion 50c of the first electrode 50 has a one-dimensional periodic structure, the relative light extraction efficiency is normalized to be 100 in the case where fifty pits are included inside one period along the direction orthogonal to the stripe portion 50c.

As the number of the pits 101 inside one period along the direction orthogonal to the stripe portion 50c increases, the uniformity of the current injection decreases; but the relative light extraction efficiency increases. In other words, by setting the number of the pits 101 inside one period to be not less than 5 and not more than 20, both the uniformity of the current injection and the laser light extraction efficiency can be realized. Thus, the optimal solution is determined from the relationship between the surface area of an opening 50d of the first electrode 50 and the efficiency of the current injection and the relationship of the effect of the periodic structure of the first electrode 50 on the diffraction effect of the light extraction.

FIG. 10 is a schematic perspective view of a semiconductor laser device according to an example, not falling under the scope of the invention.

The first electrode is not provided in the semiconductor laser device according to this example. In other words, the surface metal film 80 functions as the first electrode and supplies a voltage to the surface emitting portion. The first electrode is unnecessary in this example; therefore, the manufacturing processes can be simple; and a cost reduction is easy. The low cost is favorable in the case where the chip of the semiconductor laser device 5 is replaced. The surface metal film 80 and the surface of the surface emitting portion (the surface of the first layer 27) actually are closely adhered despite being illustrated as being separated in FIG. 10.

FIG. 11 is a configuration diagram of a laser device according to a comparative example, not falling under the scope of the invention.

A semiconductor laser element 105 that is used as a light source is an edge emitting QCL emitting single-mode laser light. The edge emitting QCL emits the laser light from the ridge waveguide in a direction orthogonal to the end surface of the ridge waveguide. In such a case, the beam diverges; and the cross section of the beam has an elliptical configuration. Therefore, the diverging emitted light is caused to be parallel light by using a collimating lens 200, etc.

The parallel light that is irradiated from the light source 105 is reflected by a reflection plate 180, subsequently is concentrated by a lens 202, and is incident on a detector 190 such as a bolometer, etc.; and the light intensity of the parallel light is detected. The reflection plate 180 can be a metal plate having openings. For a terahertz wave, such an optical configuration is large such that the planar configuration of the laser device is several tens of cmxseveral tens of cm or the like; and the adjustment of such an optical configuration is not easy.

Conversely, according to the semiconductor laser device of the embodiment, the terahertz wave is emitted from the surface emitting portion substantially perpendicular upward from the active layer 25. Therefore, a complex configuration and a large optical system are unnecessary; therefore, a small semiconductor laser device that can emit a plane terahertz wave with high efficiency is possible.

## Claims

1. A semiconductor laser device (5), comprising:
an active layer (25) configured to emit laser light of a terahertz wave by an intersubband transition, a plurality of quantum well layers being stacked in the active layer;
a first layer (27) having a first surface (21a) and being provided on the active layer (25), a plurality of pits (101) being provided in the first surface (21a) to form a two-dimensional lattice; and
a surface metal film (80) provided on the first layer (27), a plurality of openings (80a) being provided in the surface metal film (80),
the laser light passing through the plurality of openings (801) and being emitted in a direction substantially perpendicular to the active layer (25).
**characterized by**
a first electrode (50) provided between the first layer (27) and the surface metal film (80), electrically connected to a surface of the first layer (27), but insulated from the surface metal film (80),
a planar configuration of each of the pits (101) being asymmetric with respect to one of the two sides (D, E) of the two-dimensional lattice.

2. The semiconductor laser device (5) according to claim 1, wherein the lattice of the first layer (27) includes the pits (101) having configurations of prescribed regions of the first layer cut out from the first surface (21a) toward a depth direction.

3. The semiconductor laser device (5) according to claim 1, wherein the plurality of openings (80a) provided in the surface metal film (80) forms a two-dimensional lattice.

4. The semiconductor laser device (5) according to claim 2, wherein the plurality of openings (80a) provided in the surface metal film (80) forms a two-dimensional lattice.

5. The semiconductor laser device (5) according to claim 3, wherein a pitch of the lattice of the openings (80a) is different from a pitch of the lattice of the first layer (27) .

6. The semiconductor laser device (5) according to claim 4, wherein a pitch of the lattice of the openings (80a) is different from a pitch of the lattice of the first layer (27) .

7. The semiconductor laser device (5) according to claim 6, wherein
the first electrode (50) includes a frame portion and a plurality of stripe portions, two end portions of each stripe portion being linked to the frame portion, and
the plurality of stripe portions obliquely crosses the frame portion and is arranged to be mutually parallel at a prescribed pitch.

8. The semiconductor laser device (5) according to claim 7, wherein an opening of the first electrode (50) is asymmetric with respect to a line parallel to a side of the lattice of the first layer (27).

## Patentansprüche

1. Eine Halbleiterlaservorrichtung (5), umfassend:
eine aktive Schicht (25), die so konfiguriert ist, dass sie durch einen Intersubband-Übergang Laserlicht einer Terahertz-Welle emittiert, wobei in der aktiven Schicht eine Vielzahl von Quantentopfschichten gestapelt ist;
eine erste Schicht (27), die eine erste Oberfläche (21a) aufweist und auf der aktiven Schicht (25) vorgesehen ist, wobei eine Vielzahl von Vertiefungen (101) in der ersten Oberfläche (21a) vorgesehen ist, um ein zweidimensionales Gitter zu bilden; und
einen Oberflächenmetallfilm (80), der auf der ersten Schicht (27) vorgesehen ist, wobei eine Vielzahl von Öffnungen (80a) in dem Oberflächenmetallfilm (80) vorgesehen ist,
wobei das Laserlicht durch eine Vielzahl von Öffnungen (801) hindurchtritt und in einer Richtung emittiert wird, die im Wesentlichen senkrecht zu der aktive Schicht (25) ist,
**gekennzeichnet durch**
eine erste Elektrode (50), die zwischen der ersten Schicht (27) und dem Oberflächenmetallfilm (80) vorgesehen ist und elektrisch mit einer Oberfläche der ersten Schicht (27) verbunden, aber von dem Oberflächenmetallfilm (80) isoliert ist,
wobei eine planare Konfiguration jeder der Vertiefungen (101) asymmetrisch in Bezug auf eine der zwei Seiten (D,E) des zweidimensionalen Gitters ist.

2. Halbleiterlaservorrichtung (5) nach Anspruch 1, wobei das Gitter der ersten Schicht (27) die Vertiefungen (101) mit Konfigurationen von vorgeschriebenen Bereichen der ersten Schicht enthält, die von der ersten Oberfläche (21a) in Richtung einer Tiefenrichtung ausgeschnitten sind.

3. Halbleiterlaservorrichtung (5) nach Anspruch 1, wobei die Vielzahl von Öffnungen (80a), die in dem Oberflächenmetallfilm (80) vorgesehen sind, ein zweidimensionales Gitter bilden.

4. Halbleiterlaservorrichtung (5) nach Anspruch 2, wobei die Öffnungen (80a), die in dem Oberflächenmetallfilm (80) vorgesehen sind, ein zweidimensionales Gitter bilden.

5. Halbleiterlaservorrichtung (5) nach Anspruch 3, wobei ein Abstand des Gitters der Öffnungen (80a) von einem Abstand des Gitters der ersten Schicht (27) verschieden ist.

6. Halbleiterlaservorrichtung (5) nach Anspruch 4, wobei ein Abstand des Gitters der Öffnungen (80a) von einem Abstand des Gitters der ersten Schicht (27) verschieden ist.

7. Halbleiterlaservorrichtung (5) nach Anspruch 6, wobei
die erste Elektrode (50) einen Rahmenteil und eine Vielzahl von Streifenteilen aufweist, wobei zwei Endteile jedes Streifenteils mit dem Rahmenteil verbunden sind, und
die Vielzahl von Streifenabschnitten den Rahmenabschnitt schräg kreuzt und so angeordnet ist, dass sie in einem vorgeschriebenen Abstand zueinander parallel sind.

8. Halbleiterlaservorrichtung (5) nach Anspruch 7, wobei eine Öffnung der ersten Elektrode (50) asymmetrisch in Bezug auf eine Linie parallel zu einer Seite des Gitters der ersten Schicht (27) ist.

## Revendications

1. Dispositif laser à semi-conducteur (5) comprenant :
une couche active (25) configurée pour émettre une lumière laser d'une onde térahertzienne par une transition entre sous-bandes, une pluralité de couches de puits quantiques étant empilées dans la couche active ;
une première couche (27) présentant une première surface (21a) et étant fournie sur la couche active (25), une pluralité de cuvettes (101) étant fournies dans la première surface (21a) pour former un réseau bidimensionnel ; et
un film métallique de surface (80) prévu sur la première couche (27), une pluralité d'ouvertures (80a) étant prévues dans le film métallique de surface (80),
la lumière laser passant à travers la pluralité d'ouvertures (801) et étant émise dans une direction sensiblement perpendiculaire à la couche active (25),
**caractérisé par**
une première électrode (50) prévue entre la première couche (27) et le film métallique de surface (80), connectée électriquement à une surface de la première couche (27), mais isolée du film métallique de surface (80),
une configuration plane de chacune des cuvettes (101) étant asymétrique par rapport à l'un des deux côtés (D, E) du réseau bidimensionnel.

2. Dispositif laser à semi-conducteur (5) selon la revendication 1, dans lequel le réseau de la première couche (27) inclut les cuvettes (101) présentant des configurations de régions prescrites de la première couche découpées à partir de la première surface (21a) vers une direction de profondeur.

3. Dispositif laser à semi-conducteur (5) selon la revendication 1, dans lequel la pluralité d'ouvertures (80a) prévues dans le film métallique de surface (80) forme un réseau bidimensionnel.

4. Dispositif laser à semi-conducteur (5) selon la revendication 2, dans lequel la pluralité d'ouvertures (80a) prévues dans le film métallique de surface (80) forme un réseau bidimensionnel.

5. Dispositif laser à semi-conducteur (5) selon la revendication 3, dans lequel un pas du réseau des ouvertures (80a) est différent d'un pas du réseau de la première couche (27).

6. Dispositif laser à semi-conducteur (5) selon la revendication 4, dans lequel un pas du réseau des ouvertures (80a) est différent d'un pas du réseau de la première couche (27).

7. Dispositif laser à semi-conducteur (5) selon la revendication 6, dans lequel
la première électrode (50) inclut une partie de cadre et une pluralité de parties de bande, deux parties d'extrémité de chaque partie de bande étant liées à la partie de cadre, et
la pluralité de parties de bande croise obliquement la partie de cadre et est agencée pour être mutuellement parallèle à un pas prescrit.

8. Dispositif laser à semi-conducteur (5) selon la revendication 7, dans lequel une ouverture de la première électrode (50) est asymétrique par rapport à une ligne parallèle à un côté du réseau de la première couche (27).
